# EUROPEAN PATENT APPLICATION

(11) **EP 2 623 998 A2**
(43) Date of publication of application: **07.08.2013**
(21) Application number: 13152597.4
(22) Date of filing: 24.01.2013
(51) Int. Cl.: G01R 31/02

(54) **System and method for health monitoring of power cables**

(30) Priority: 31.01.2012 US 201213362481
(71) Applicant: General Electric Company, Schenectady, New York 12345 (US)
(72) Inventor: Devupalli, Srikumar, 500081 Hyderabad (IN)
(74) Representative: Picker, Madeline Margaret

(57) **Abstract**

A shield 210 of a power cable 120 diverts leakage current to ground. During normal operation, the leakage current is steady. An increase in leakage current can lead to a failure mode of the power cable 120. Systems and methods are described to measure leakage current with a current transducer 230, which generates a current signal based on the leakage current, and to process the current signal to provide an output of the health of the power cable 120.

## Description

### BACKGROUND OF THE INVENTION

The subject matter disclosed herein relates to health monitoring of power cables.

In a power cable, a shield is a metallic layer that encloses the conductor and is connected to a ground strip. The shield diverts leakage current to ground. When the leakage current through the shield increases to exceed a certain value, a fault mode occurs in the power cable.

### BRIEF DESCRIPTION OF THE INVENTION

According to one aspect of the invention, a power cable health monitoring system includes a shield surrounding the power cable and configured to divert leakage current from the power cable to ground; a current transducer configured to measure the leakage current and output a current signal corresponding to the leakage current; and a processor configured to receive the current signal and output an indication of the power cable health based on the current signal

According to another aspect of the invention, a starter system for a gas turbine engine includes a static starter configured to output three-phase current; a set of three power cables configured to carry the three-phase current from the static starter; a set of three shields, each shield configured to surround a corresponding one of the set of three power cables and to divert leakage current to ground; a current transducer configured to measure the leakage current through each of the set of three shields and output a current signal corresponding to each of the leakage current measurements; a processor configured to receive the current signal corresponding to each of the leakage current measurements and output an indication of a health of each of the set of three power cables based on the corresponding current signal; and a synchronous generator configured to receive the three-phase current from the static starter through the set of three power cables and supply power to a rotor of the gas turbine engine.

According to yet another aspect of the invention, a method of monitoring health of a power cable includes detecting leakage current through a shield of the power cable; generating a current signal based on the leakage current detected through the shield; processing the current signal to determine the health of the power cable; and outputting a status based on the current signal processed to determine the health.

These and other advantages and features will become more apparent from the following description taken in conjunction with the drawings.

### BRIEF DESCRIPTION OF THE DRAWINGS

The subject matter, which is regarded as the invention, is particularly pointed out and distinctly claimed in the claims at the conclusion of the specification. The foregoing and other features, and advantages of the invention are apparent from the following detailed description taken in conjunction with the accompanying drawings in which:
FIG. 1 is a block diagram of a starting system of a gas turbine power plant according to an embodiment of the present invention;
FIG. 2 is a block diagram of a power cable health monitoring system of the starting system shown at FIG. 1 according to an embodiment of the invention; and
FIG. 3 shows processes included in a method of monitoring the health of a power cable according to an embodiment of the invention.

The detailed description explains embodiments of the invention, together with advantages and features, by way of example with reference to the drawings.

### DETAILED DESCRIPTION OF EMBODIMENTS OF THE INVENTION

Embodiments of the present invention include systems and methods to monitor the health of a power cable to allow action to be taken before a fault condition is reached. Although an example system (starting system of a gas turbine power plant) is detailed below, it is to be understood that the embodiments of the present invention may be applied to any system that would benefit from monitoring leakage current and cable health.

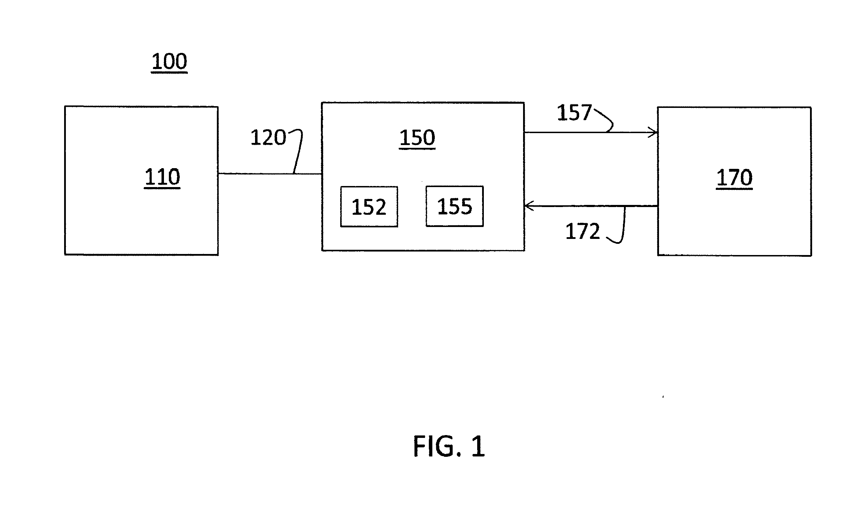

FIG. 1 is a block diagram of a starting system 100 of a gas turbine power plant according to an embodiment of the present invention. During normal operation, the gas turbine 170 supplies mechanical energy 172 to the synchronous generator 150. Before the gas turbine 170 can perform its function, it must first reach its required operating speed. A gas turbine 170 typically takes 30 minutes to reach full speed without a load. At the start of operation, the synchronous generator 150 aids the gas turbine 170 in reaching its required speed with the help of a static starter 110. The gas turbine 170 speed increases from 0 rpm to a required speed (e.g., 3000 rpm or 3600 rpm depending on a frequency of 50 Hz or 60 Hz). The static starter 110 serves as a variable frequency drive. The static starter 110 provides alternating current (AC) to the synchronous generator 150 stator windings 152. Flow of the AC from the static starter 110 through the stator windings 152 generates a flux. At the same time, high direct current (DC) flowing in the rotor winding 155 also generates flux. The flux linkage 157 of the flux generated at the stator windings 152 and the rotor 155 helps the gas turbine 170 acquire its required speed. The supply of AC from the static starter 110 to the stator windings 152 is via power cables 120.

The health of the power cable 120 must be maintained in order to complete the operation of brining the gas turbine 170 to its required speed. In the example starting system 100, the power cable 120 is comprised of a set of three power cables 120. Specifically, three-phase power cables 120 run from the static starter 110 to the synchronous generator 150 stator windings 152. Thus, the health of each of the power cables 120 must be monitored and maintained to successfully start the gas turbine 170.

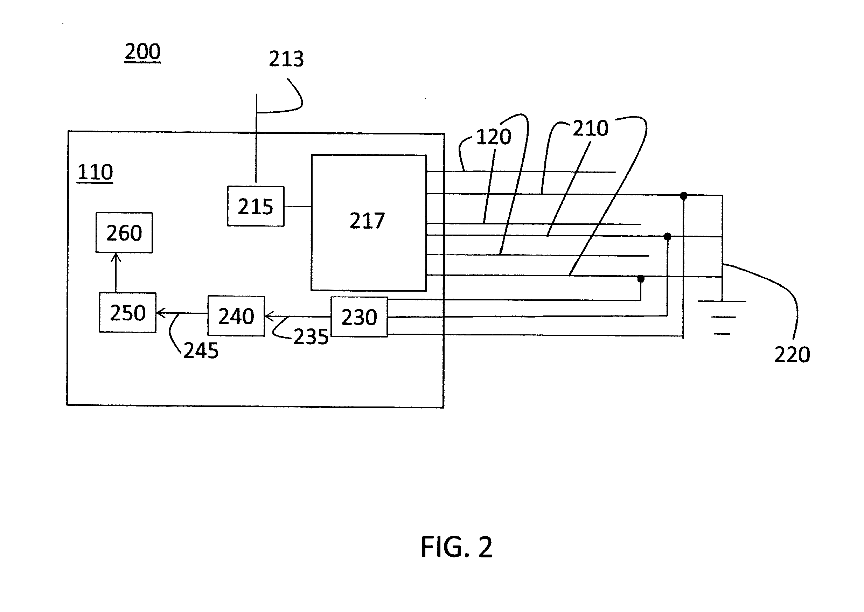

FIG. 2 is a block diagram of a power cable 120 health monitoring system 200 of the starting system 100 shown at FIG. 1 according to an embodiment of the invention. As shown, the health monitoring system 200 is part of the static starter 110 in the starting system 100 of FIG. 1. The static starter 110 includes converter circuits 215 to convert AC input 213 into direct current (DC) and inverter circuits 217 to convert the DC back to AC at a desired frequency. The AC out of the inverter circuits 217 is supplied as three-phase current through three power cables 120 to the synchronous generator 150. The health monitoring system 200 includes a shield 210 corresponding to each power cable 120, a current transducer 230, an input/output (I/O) board 240, and a processor 250. Each shield 210 is connected to a ground strip 220 and diverts leakage current of its corresponding power cable 120 to ground. The shield 210 may be comprised of a layer of copper, for example.

The leakage current flowing through the shield 210 maintains a stable value during healthy conditions of the power cable 120. During a fault condition, the leakage current flowing through the shield 210 increases. The current transducer 230 measures the leakage current through the shield 210 and sends a current signal 235 to the I/O board 240. Although a single current transducer 230 is shown by FIG. 2, one or more current transducers 230 may be used with multiple power cables 120 and their respective shields 210. The current signal 235 from the current transducer 230 may be a 4 to 20 mA current signal, for example. The current signal 235 is forwarded to the processor 250 via the interconnection 245. The interconnection 245 may be a ribbon cable, for example. The processor 250 detects the current signal 235 sensed by the current transducer 230 and annunciates information to a user via an output 260.

The current transducer 230, I/O board 240, processor 250, and output 260 may be housed together or separately. The I/O board 240 functionality may be incorporated in the processor 250. The processor 250 may include one or more memory devices and may be comprised of one or more processors 250. The output 260 may provide an audible or visual output or both. The output 260 may provide a visual and/or audible alarm if a predetermined threshold leakage current is exceeded or may allow continuous health checks of the power cable 120 through an indication of the current signal 235 from the transducer 230. If a certain leakage current is exceeded in one of the power cables 120, an operator may be prompted to shut off the static starter 110, perform maintenance of the power cable 120, and then re-start the static starter 110 until the gas turbine 170 is pulled to its required speed.

As noted, in the example starting system 100 of the gas turbine 170 discussed with reference to FIG. 1, the transducer 230, I/O board 240, processor 250, and output 260 may all be part of the static starter 110. However, in a different system, the current transducer 230, I/O board 240, processor 250, and output 260 may all be housed separately or together and may be separate from or integrated with other parts of the system using the health monitoring system 200. Further, while three-phase current is supplied to the synchronous generator 150 by three power cables 120 from the static starter 110, a different system may comprise one to a different number of power cables 120. In such a system, each power cable 120 would still have a corresponding shield 210, and one or more current transducers 230 would sense the leakage current for each power cable 120.

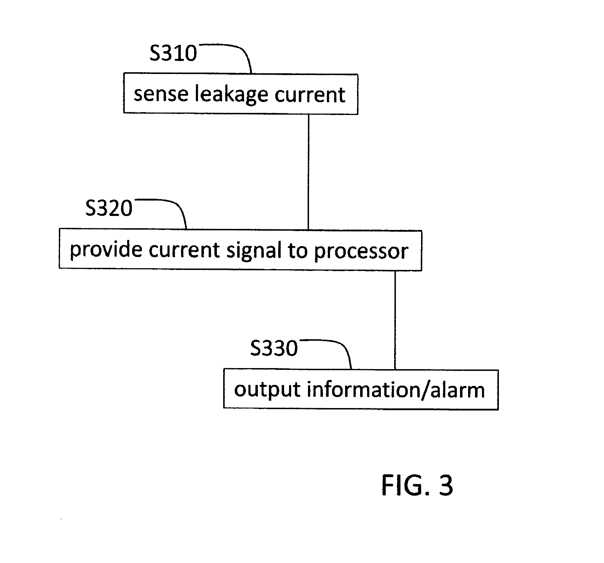

FIG. 3 shows processes included in a method of monitoring the health of a power cable 120. At block S310, sensing the leakage current includes arranging a current transducer 230 per power cable 120 to measure shield 210 current (leakage current) for that power cable 120 and generating a current signal 235. Providing the current signal 235 to the processor at S320 includes the current transducer 230 sending the current signal 235 to the I/O board 240 and the I/O board 240 passing on the current signal 235 through an interconnection 245 to the processor 250. At the processor, the current signal 235 is processed, and outputting information/alarm at S330 includes providing a visual and/or audible output to a user at the output 260.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

## Claims

1. A power cable health monitoring system (200), comprising:
a shield (210) surrounding a power cable (120) and configured to divert leakage current from the power cable to ground;
a current transducer (230) configured to measure the leakage current and output a current signal corresponding to the leakage current; and
a processor (250) configured to receive the current signal and output an indication of the power cable health based on the current signal.

2. The system according to claim 1, further comprising:
an input/output board (240) configured to receive the current signal from the current transducer (230) and transmit the current signal to the processor (250).

3. The system according to claim 1 or claim 2, wherein the processor (250) is configured to output an alarm when the current signal indicates that the leakage current exceeds a threshold value.

4. The system according to claim 3, wherein the threshold value is a user input value or a predetermined value based on parameters of the power cable.

5. The system according to claim 3 or claim 4, wherein the processor outputs the alarm as an audible alarm, and/or is a visible alarm.

6. The system according to any preceding claim, wherein the processor (250) outputs the indication of the power cable health periodically when the current signal indicates that the leakage current is below a threshold value.

7. A starter system (100) for a gas turbine engine (170), comprising:
a static starter (110) configured to output three-phase current;
a set of three power cables (120) configured to carry the three-phase current from the static starter;
a set of three shields (210), each shield configured to surround a corresponding one of the set of three power cables (120) and to divert leakage current to ground;
a current transducer (230) configured to obtain a leakage current measurement through each of the set of three shields (210) and output a current signal corresponding to each leakage current measurement;
a processor (250) configured to receive the current signal corresponding to each leakage current measurement and output an indication of a health of a corresponding cable from the set of three power cables; and
a synchronous generator (150) configured to receive the three-phase current from the static starter (110) through the set of three power cables (120) and supply power to a rotor of the gas turbine engine (170).

8. The system according to claim 7, wherein the processor outputs an alarm when any current signal corresponds to a leakage current that exceeds a threshold value.

9. The system according to claim 8, wherein the alarm is an audible alarm.

10. The system according to 8 or claim 9, wherein the alarm is a visible alarm and the alarm indicates which of the set of three power cables corresponds to the current signal that generated the alarm.

11. A method of monitoring health of a power cable, comprising:
detecting leakage current through a shield of the power cable;
generating a current signal based on the leakage current detected through the shield;
processing the current signal to determine a health of the power cable; and
outputting a status based on the current signal processed to determine the health.

12. The method according to claim 11, wherein the detecting the leakage current includes arranging a current transducer to measure current through the shield.

13. The method according to claim 11 or claim 12, wherein the outputting the status includes outputting an alarm when the current signal indicates that the leakage current exceeds a threshold value.

14. The method according to claim 13, wherein the threshold value is predetermined based on parameters of the power cable, or is input by a user.

15. The method according to any one of claims 12 to 14, wherein the outputting the status includes outputting an indication of the leakage current periodically.
